# EUROPÄISCHE PATENTANMELDUNG

(11) **EP 0 945 528 A1**
(43) Veröffentlichungstag der Anmeldung: **29.09.1999**
(21) Anmeldenummer: 98120269.0
(22) Anmeldetag: 27.10.1998
(51) Int. Cl.: C30B 15/02

(54) **Kristall-Ziehanlage**

(30) Priorität: 26.03.1998 DE 19813453
(71) Anmelder: Leybold Systems GmbH, 63450 Hanau (DE)
(72) Erfinder: Altekrüger, Burkhard, Dr., 63755 Alzenau (DE); Aufreiter, Joachim, 63755 Alzenau (DE)
(74) Vertreter: Schlagwein, Udo, Dipl.-Ing.

(57) **Zusammenfassung**

Eine Kristall-Ziehanlage zur Erzeugung eines Kristallblockes hat ein Nachchargierrohr (7), über welches Granulat (17) in einen innerhalb eines Behälters (1) angeordneten Tiegel (2) mit einer Schmelze (3) gelangt. Dieses Nachchargierrohr (7) hat zwischen einer inneren Wand (18) und einer äußeren Wand (19) einen Ringraum (20), welcher an der unteren Stirnseite des Nachchargierrohres (7) offen ist und zur Zufuhr von Schutzgas mit der Schutzgasquelle (13) Verbindung hat. Dieses Schutzgas kühlt das Nachchargierrohr (7) und bildet rund um seinen Auslass herum einen Gasschleier, der verhindert, dass feinere Fraktionen des Chargiermaterials in den Ziehraum gelangen können.

## Beschreibung

Die Erfindung betrifft eine Kristall-Ziehanlage zur Erzeugung eines Kristallblockes, welche einen Tiegel für den Kristallblock bildendes, schmelzbares Material hat und welche ein in den Tiegel führendes Nachchargierrohr zur Zuführung des schmelzbaren Materials in Granulatform aufweist.

Kristall-Ziehanlagen der vorstehenden Art sind zum Ziehen von kristallinen Blöcken aus Halbleitermaterial nach dem Czochralski-Verfahren bekannt und arbeiten meist kontinuierlich, indem während des Ziehens des Kristallblockes das schmelzbare Material in Form von Granulat ständig zugeführt wird. Als Beispiel für den Stand der Technik sei auf die DE 28 21 481 verwiesen. Vergleichbare Kristall-Ziehanlagen werden jedoch auch für semikontinuierliche Czochralski-Ziehverfahren benutzt. Das Nachchargierrohr besteht ebenso wie der Tiegel aus Quarzgut.

Bei Betrieb solcher Kristall-Ziehanlagen muss oftmals festgestellt werden, dass es im Nachchargierrohr zu Verstopfungen kommt. Hierdurch wird ein Stillstand der Anlage erforderlich, was relativ hohe Kosten verursacht. Ein weiterer Nachteil bekannter Kristall-Ziehanlagen liegt darin, dass beim Auftreffen feinerer Fraktionen auf den Flüssigkeitsspiegel der Schmelze im Tiegel diese Fraktionen auf dem Flüssigkeitsspiegel "tanzen" statt zu schmelzen und dadurch in den Ziehraum oberhalb der Schmelze gelangen und diesen verunreinigen.

Der Erfindung liegt das Problem zugrunde, eine Kristall-Ziehanlage der eingangs genannten Art so zu gestalten, dass die Gefahr von Verstopfungen im Nachchargierrohr möglichst gering ist und es nicht zu einem Übertritt feinkörniger Fraktionen in den Ziehraum oberhalb des Flüssigkeitsspiegels kommen kann.

Dieses Problem wird erfindungsgemäß dadurch gelöst, dass dass das Nachchargierrohr zwischen einer inneren Wand und einer äußeren Wand einen Ringraum aufweist, welcher an der unteren Stirnseite des Nachchargierrohres offen ist und zur Zufuhr von Schutzgas mit der Schutzgasquelle Verbindung hat.

Diese erfindungsgemäße Lösung des Problems baut auf der Erkenntnis auf, dass die feineren, staubförmigen Teilchen im Nachchargiermaterial durch Anschmelzen an der Wandung des Nachchargierrohres haften. Sie bilden dort einen Klebefilm, an welchem später auch die gröberen Fraktionen des Granulates haften und schmelzen. Diese Gefahr des Anschmelzens feiner Fraktionen ist bei einem beheizten Nachchargierrohr, wie es die eingangs genannte DE 28 21 481 beschreibt, ganz besonders groß. Der Ringraum und das in ihm strömende Gas sorgen dafür, dass die Temperatur der inneren Wandfläche des Nachchargierrohres niedriger ist als bei den bisher bekannten Nachchargierrohren, wodurch die Gefahr eines Anbackens von Nachchargiermaterial vermindert wird. Durch den erfindungsgemäßen, gasdurchströmten Ringraum des Nachchargierrohres bildet sich zugleich rund um den Auslass des Nachchargierrohres ein Gasschleier, der verhindert, dass Nachchargiermaterial in den Ziehraum eintreten kann.

Da üblicherweise Kristall-Ziehanlagen mit Argon als Schutzgas arbeiten, ist der Aufwand zur Bildung des Gasschleiers am Austritt des Nachchargierrohres besonders gering, wenn der Ringraum mit einer Schutzgasquelle für Argon Verbindung hat.

Besonders wirksam kann das Nachchargierrohr gekühlt werden, wenn der Ringraum mit einer Schutzgasquelle für Helium Verbindung hat.

Zur weiteren Verminderung der Temperatur der inneren Wand des Nachchargierrohres trägt es bei, wenn die innere Wand des Nachchargierrohres zur Seite des Ringraumes hin zumindest im unteren Bereich außenseitig mit einem mattierenden Schliff versehen ist.

Ganz besonders wirksam kann man der Gefahr einer Verstopfung des Nachchargierrohres begegnen, wenn dem Nachchargierrohr außerhalb des Behälters ein Feinstaubseparator vorgeschaltet ist. Durch einen solchen Feinstaubseparator können die am Granulat haftenden, feinen Stäube entfernt werden, bevor das Granulat in das Nachchargierrohr gelangt, so dass die eigentliche Ursache für Verstopfungen beseitigt wird. Zugleich wird durch den Feinstaubseparator die Gefahr einer Staubentwicklung im Ziehraum herabgesetzt.

Besonders einfach ist der Feinstaubseparator gestaltet, wenn er als mit einem für das schmelzbare Material inerten Schutzgas arbeitender, pneumatischer Sichter ausgebildet ist.

Man könnte den Feinstaubseparator als einen Windsichter ausbilden, in welchem sich über eine längere Strecke eine Wirbelschicht ausbildet. Dadurch bestünde jedoch die Gefahr, dass sich im Feinstaubseparator durch Aneinandereiben des Granulates und durch Reiben des Granulates an den Wandungen des Windsichters Stäube bilden. Die Gefahr einer Bildung zusätzlicher Stäube kann vermieden werden, wenn gemäß einer anderen Weiterbildung der Erfindung der Feinstaubseparator übereinander eine um eine Ringöffnung zum Passieren des schmelzbaren Materials herum angeordnete Ringdüse zum Zuführen des Schutzgases und koaxial darüber eine zweite Ringdüse zum Absaugen des Schutzgases aufweist. Ein solcher Feinstaubseparator hat den zusätzlichen Vorteil, dass er sehr kompakt ausgebildet ist und deshalb wenig Platz beansprucht.

Da Kristall-Ziehanlagen für Siliziumblöcke üblicherweise mit Argon als Schutzgas arbeiten, ist es vorteilhaft, wenn auch der Feinstaubseparator zum Arbeiten mit einer Schutzgasquelle für Argon Verbindung hat. Man kann dann eine geringe Teilmenge Argon von der Schutzgasquelle für den Behälter mit dem Tiegel abzweigen.

Das der Schmelze zugeführte Granulat kann beim Passieren des Feinstaubseparators zugleich durch das zugeführte Gas gekühlt werden, wenn der Feinstaubseparator zum Arbeiten mit einer Schutzgasquelle für Helium Verbindung hat.

Zur weiteren Verminderung der Gefahr des Anbackens von feineren Fraktionen im Nachchargierrohr trägt es bei, wenn der von der inneren Wand begrenzte Förderweg des Nachchargierrohres zur Erzeugung eines Spülgasstromes an seiner oberen Seite ebenfalls mit der Schutzgasquelle verbunden ist.

Die Erfindung lässt verschiedene Ausführungsformen zu. Zur weiteren Verdeutlichung ihres Grundprinzips ist eine davon in der Zeichnung dargestellt und wird nachfolgend beschrieben. Die Zeichnung zeigt in
- Fig.1: einen senkrechten Schnitt durch eine Kristall-Ziehanlage nach der Erfindung,
- Fig.2: eine schematische Darstellung des Bereiches eines Nachchargierrohres der Kristall-Ziehanlage.

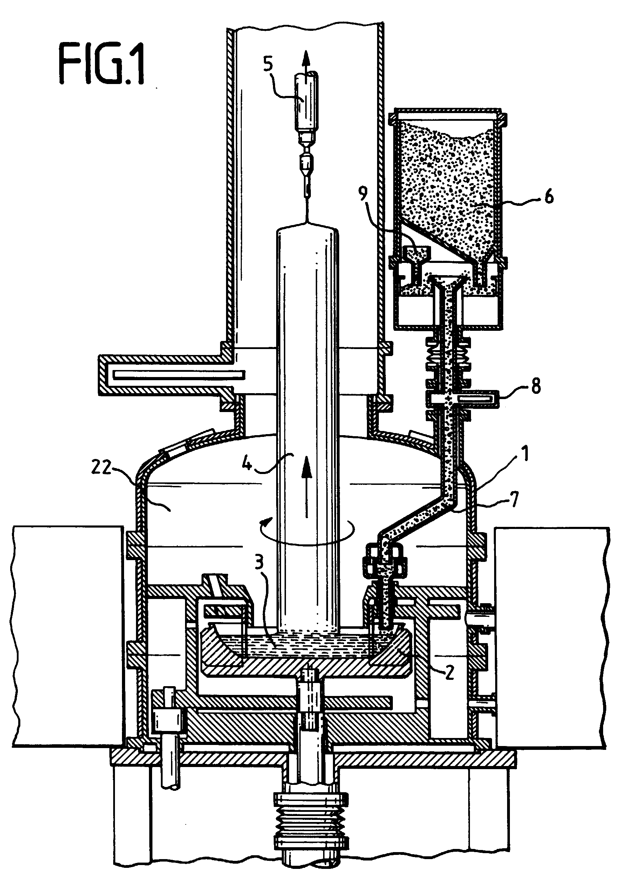

Die Figur 1 zeigt einen geschlossenen Behälter 1, in welchem ein Tiegel 2 aus Quarzgut angeordnet ist. In diesem Tiegel 2 befindet sich eine Schmelze 3 aus Silizium, aus der in einem Ziehraum 22 ein Kristallblock 4 mittels einer Ziehvorrichtung 5 gezogen wird. Hierzu rotiert der Kristallblock 4 um seine Längsachse und wird mit der Geschwindigkeit des Kristallwachstums gleichmäßig nach oben gezogen.

Außerhalb des Behälters 1 ist ein Granulatspeicher 6 angeordnet, aus dem Siliziumgranulat über ein Nachchargierrohr 7 der Schmelze 3 zugeführt wird. Ein Feinstaubseparator 8 ist außerhalb des Behälters 1 zwischen ihm und dem Granulatspeicher 6 angeordnet. Über das Nachchargierrohr 7 kann der Schmelze 3 auch Dotiermaterial aus einem Dotiermaterialspeicher 9 zugeführt werden.

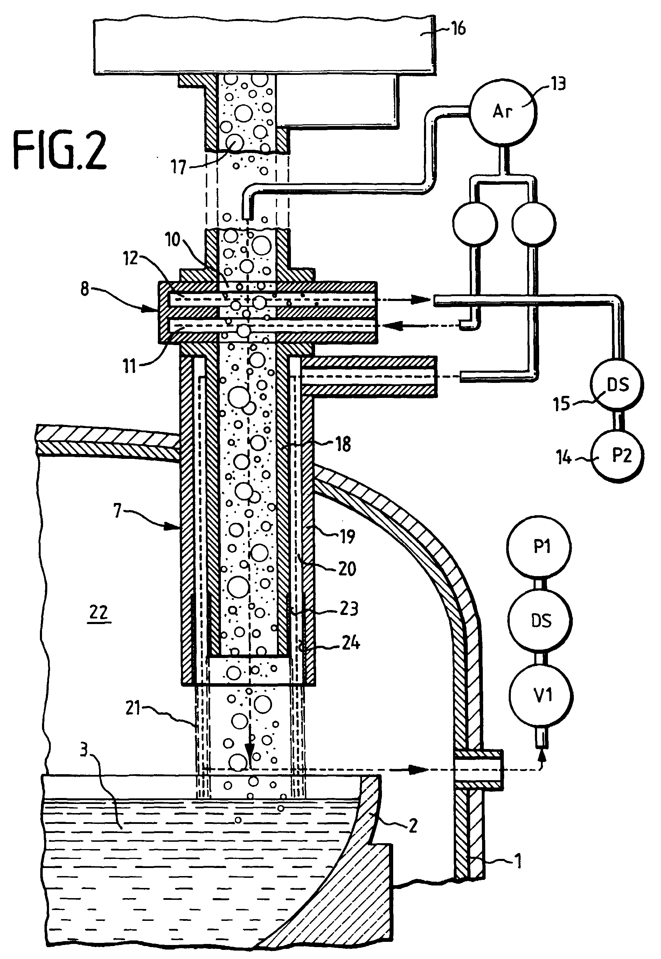

Die Prinzipskizze gemäß Figur 2 verdeutlicht die Gestaltung des Feinstaubseparators 8 und des Nachchargierrohres 7. Der Feinstaubseparator 8 hat eine Ringöffnung 10, die von zwei unmittelbar übereinander angeordneten Ringdüsen 11, 12 umschlossen ist. Die Ringdüse 11 ist mit einer Argon-Schutzgasquelle 13 verbunden, so dass über sie Argon in die Ringöffnung 10 zu strömen vermag, welches unmittelbar oberhalb der Ringdüse 11 über die Ringdüse 12 abgesaugt wird, wozu die Anlage eine Pumpe 14 mit einem vorgeschalteten Staubfilter 15 hat. Schematisch angedeutet ist in Figur 2 ein Förderer 16, auf dem das als Granulat 17 ausgebildete Nachchargiermaterial dem Feinstaubseparator 8 zugeführt wird und von dem es in die Ringöffnung 10 fällt. Innerhalb der Ringöffnung 10 wird dieses Granulat 17 durch das vom Argon gebildete Gaspolster von an ihm anhaftenden Staub befreit, so dass weitgehend staubfreies Granulat 17 in das Nachchargierrohr 7 gelangt, durch welches es in die Schmelze 3 fällt.

Das Nachchargierrohr 7 ist doppelwandig ausgeführt. Es hat zwischen einer inneren Wand 18 und einer äußeren Wand 19 einen Ringraum 20, welcher an der unteren Stirnseite des Nachchargierrohres 7 offen ist und der Zufuhr von Schutzgas aus der Schutzgasquelle 13 dient. Da der Ringraum 18 des Nachchargierrohres 7 an der unteren Stirnseite des Nachchargierrohres 7 offen ist, strömt dort ein Gasschleier 21 aus dem Nachchargierrohr 7 heraus und verhindert, dass durch das Nachchargierrohr 7 fallende Staubteilchen zur Seite hin abwandern und dadurch in den Ziehraum 22 gelangen können.

Angedeutet ist in Figur 2, dass auch der von der inneren Wand 18 begrenzte Förderweg des Nachchargierrohres 3 zur Erzeugung eines Spülgasstromes an seiner oberen Seite ebenfalls mit der Schutzgasquelle 13 verbunden sein kann. Weiterhin ist in Figur 2 zu sehen, dass die innere Wand 18 und die äußere Wand 19 des Nachchargierrohres 7 zur Seite des Ringraumes 20 hin zumindest im unteren Bereich außenseitig mit einem mattierenden Schliff 23, 24 versehen sind, um die Wärmeeinstrahlung herabzusetzen.

### Bezugszeichenliste

- 1: Behälter
- 2: Tiegel
- 3: Schmelze
- 4: Kristallblock
- 5: Ziehvorrichtung
- 6: Granulatspeicher
- 7: Nachchargierrohr
- 8: Feinstaubseparator
- 9: Dotiermaterialspeicher
- 10: Ringöffnung
- 11: Ringdüse
- 12: Ringdüse
- 13: Schutzgasquelle
- 14: Pumpe
- 15: Staubfilter
- 16: Förderer
- 17: Granulat
- 18: innere Wand
- 19: äußere Wand
- 20: Ringraum
- 21: Gasschleier
- 22: Ziehraum
- 23: Schliff
- 24: Schliff

## Patentansprüche

1. Kristall-Ziehanlage zur Erzeugung eines Kristallblockes, welche einen Tiegel für den Kristallblock bildendes, schmelzbares Material hat und welche ein in den Tiegel führendes Nachchargierrohr zur Zuführung des schmelzbaren Materials in Granulatform aufweist, **dadurch gekennzeichnet,** dass das Nachchargierrohr (7) zwischen einer inneren Wand (18) und einer äußeren Wand (19) einen Ringraum (20) aufweist, welcher an der unteren Stirnseite des Nachchargierrohres (7) offen ist und zur Zufuhr von Schutzgas mit der Schutzgasquelle (13) Verbindung hat.

2. Kristall-Ziehanlage nach Anspruch 1, **dadurch gekennzeichnet,** dass der Ringraum (20) mit einer Schutzgasquelle (13) für Argon Verbindung hat.

3. Kristall-Ziehanlage nach Anspruch 2, **dadurch gekennzeichnet,** dass der Ringraum (20) mit einer Schutzgasquelle (13) für Helium Verbindung hat.

4. Kristall-Ziehanlage nach zumindest einem der vorangehenden Ansprüche, **dadurch gekennzeichnet,** dass die innere Wand (18) und/oder die äußere Wand (19) des Nachchargierrohres (7) zur Seite des Ringraumes (20) hin zumindest im unteren Bereich außenseitig mit einem mattierenden Schliff (23, 24) versehen sind.

5. Kristall-Ziehanlage nach zumindest einem der vorangehenden Ansprüche, **dadurch gekennzeichnet,** dass dem Nachchargierrohr (7) außerhalb des Behälters (1) ein Feinstaubseparator (8) vorgeschaltet ist.

6. Kristall-Ziehanlage nach Anspruch 5, **dadurch gekennzeichnet,** dass der Feinstaubseparator (8) als mit einem für das schmelzbare Material inerten Schutzgas arbeitender, pneumatischer Sichter ausgebildet ist.

7. Kristall-Ziehanlage nach den Ansprüchen 5 oder 6, **dadurch gekennzeichnet,** dass der Feinstaubseparator (8) übereinander eine um eine Ringöffnung (10) zum Passieren des schmelzbaren Materials herum angeordnete Ringdüse (11) zum Zuführen des Schutzgases und koaxial darüber eine zweite Ringdüse (12) zum Absaugen des Schutzgases aufweist.

8. Kristall-Ziehanlage nach zumindest einem der vorangehenden Ansprüche 5 bis 7, **dadurch gekennzeichnet,** dass der Feinstaubseparator (8) zum Arbeiten mit einer Schutzgasquelle (13) für Argon Verbindung hat.

9. Kristall-Ziehanlage nach zumindest einem der vorangehenden Ansprüche S bis 8, **dadurch gekennzeichnet,** dass der Feinstaubseparator (8) zum Arbeiten mit einer Schutzgasquelle (13) für Helium Verbindung hat.

10. Kristall-Ziehanlage nach zumindest einem der vorangehenden Ansprüche, **dadurch gekennzeichnet,** dass der von der inneren Wand (18) begrenzte Förderweg des Nachchargierrohres (3) zur Erzeugung eines Spülgasstromes an seiner oberen Seite ebenfalls mit der Schutzgasquelle (13) verbunden ist.
